# EUROPÄISCHE PATENTSCHRIFT

(11) **EP 2 617 073 B1**
(45) Veröffentlichungstag und Bekanntmachung des Hinweises auf die Patenterteilung: **27.12.2017**
(21) Anmeldenummer: 11748952.6
(22) Anmeldetag: 26.08.2011
(51) Int. Cl.: H01L 41/053, F16F 1/02, F02M 51/06

(54) **ROHRFEDER ZUR AUFNAHME UND ZUM VORSPANNEN EINES AKTORS**
TUBULAR SPRING FOR RECEIVING AND PRETENSIONING AN ACTUATOR
RESSORT TUBULAIRE DESTINÉ À RECEVOIR ET PRÉCONTRAINDRE UN ACTIONNEUR

(30) Priorität: 14.09.2010 DE 102010040773
(43) Veröffentlichungstag der Anmeldung: 24.07.2013
(73) Patentinhaber: Continental Automotive GmbH, 30165 Hannover (DE)
(72) Erfinder: HAMANN, Christoph, 93107 Thalmassing (DE); DICK, Jürgen, 93164 Laaber (DE)
(86) Internationale Anmeldenummer: PCT/EP2011/064709
(87) Internationale Veröffentlichungsnummer: WO 2012/034837

(56) Entgegenhaltungen:
- EP-A1- 1 519 072
- EP-A1- 1 605 159
- WO-A1-2004/097208

## Beschreibung

Die Erfindung betrifft eine Rohrfeder zur Aufnahme und zum Vorspannen eines piezoelektrischen oder magnetostriktiven Aktors nach dem Oberbegriff des Anspruchs 1 und eine Aktoreinheit gemäß Anspruch 10 mit einer entsprechenden Rohrfeder.

In der Kraftfahrzeugtechnik werden üblicherweise piezoelektrische oder magnetostriktive Aktoren in Aktoreinheiten verwendet, um beispielsweise Brennstoffeinspritzventile von Brennkraftmaschinen zu betätigen. Zur Vermeidung oder zumindest Reduzierung von Zug- und / oder Scherkräften werden solche Aktoren zumeist durch eine Feder vorgespannt. Solche Federn sind zumeist als Rohrfeder ausgebildet, die als Hohlkörper zur Aufnahme des Aktors dienen.

Eine entsprechende Rohrfeder ist beispielsweise aus der WO 00/08353 A1 bekannt. Die dort gezeigte Rohrfeder ist als elastischer Hohlkörper ausgebildet, der den darin befindlichen piezoelektrischen Aktor vorspannt. Der Hohlkörper ist mit Ausnehmungen versehen, die knochenförmig ausgebildet sind und quer zur Hohlkörperachse verlaufen. Die Rohrfeder wird aus Federstahlband gefertigt, aus dem zunächst die Ausnehmungen ausgestanzt werden und danach einzelne Zuschnitte aus dem Federstahlband auf das für die Rohrfeder gewünschte Maß zugeschnitten werden. Nachfolgend werden die Zuschnitte gerollt, so dass sich zwei aneinanderliegende Stoßkanten in Längsrichtung der Rohrfeder ausbilden. Zum Fixieren der Rohrfeder werden diese Stoßkanten geschweißt oder so durch obere und untere Abdeckplatten fixiert, so dass die Stoßkanten aneinander anliegen. Insbesondere bei nicht verschweißten aneinanderliegenden Stoßkanten kann es zu ungleichmäßigen Belastungen und Verformungen in der Rohrfeder kommen.

Aus der DE 10 344 621 A1 ist eine Rohrfeder bekannt, die ebenfalls knochenförmige Ausnehmungen senkrecht zur Längsachse der Rohrfeder aufweist, die durch Stege zwischen den Ausnehmungen voneinander beabstandet sind. Die Stege weisen je nach ihrer Position unterschiedliche Abstände auf, so dass sich ungleichmäßige mechanische Belastungen der Rohrfeder insbesondere ausgehend von den beiden nicht verschweißten Stoßkanten möglichst gleichmäßig in Umfangsrichtung auf die Rohrfederstruktur verteilen.

Weitere Vorrichtungen nach dem Stand der Technik sind aus WO 2004 / 097208 A1, EP 1 605 159 A1 und EP 1 519 072 A1 bekannt.

Ausgehend von den beiden Stoßkanten der Rohrfeder, insbesondere, wenn diese nicht verschweißt sind, ergeben sich jedoch nicht nur ungleichmäßige Belastungen und Verformungen entlang des Umfangs der Rohrfeder, sondern auch in deren Längsrichtung, so dass ein Verteilen von ungleichmäßigen Querkräften in Umfangsrichtung der Rohrfeder, wie in der DE 10 344 621 gezeigt, nur einen Teil der auftretenden ungleichmäßigen Belastungen innerhalb der Rohrfeder ausgleicht.

Aufgabe der vorliegenden Erfindung ist es deshalb, eine Rohrfeder zur Aufnahme und zum Vorspannen eines piezoelektrischen oder magnetostriktiven Aktors einer Aktoreinheit bereitzustellen, welche insbesondere zur Betätigung eines Brennstoffeinspritzventils für Brennkraftmaschinen geeignet ist und bei der ungleichmäßige Belastungen und Verformungen in der Rohrfeder sowohl in deren Längs- als auch in deren Querrichtung möglichst gering gehalten werden.

Diese Aufgabe wird gelöst durch eine Rohrfeder mit den Merkmalen gemäß Anspruch 1.

Die erfindungsgemäße Rohrfeder weist eine Reihe von Ausnehmungen auf, die üblicherweise aus einem Federstahl-Rohling ausgestanzt werden. Nach Rollen der Feder reichen die Ausnehmungen von der Außenobenfläche der Rohrfeder bis zur Innenoberfläche. Jede Ausnehmung weist an einer der beiden Oberflächen, der Außenoberfläche oder der Innenoberfläche, eine Querschnittskonturlinie auf. Auf jeweils einer Oberflächenseite legt die Querschnittskontorlinie jeweils eine maximale Längsausdehnung der Ausnehmung sowie jeweils eine maximale Querausdehnung fest, wobei die Querausdehnung im Wesentlichen senkrecht zur Längsausdehnung ausgerichtet ist. Je nach verwendetem Stanzwerkzeug und je nach verwendetem Stanzverfahren können die Querschnittskonturlinien auf der Außenoberfläche und auf der Innenoberfläche in einer gemeinsamen Projektionsebene ggf. nicht deckungsgleich sein, so dass sich die maximale Längsausdehnung und / oder die maximale Querausdehnung der Ausnehmung auf der Außenoberfläche von derjenigen der Innenoberfläche unterscheidet.

Erfindungsgemäß unterscheiden sich die Querausdehnungen zweier Ausnehmungen jedoch bereits auf derselben der beiden Oberflächen der Rohrfeder voneinander. Auf diese Weise können Bereiche der Rohrfeder strukturell gestärkt oder geschwächt werden, um die Belastungen und Verformungen innerhalb der Rohrfeder gleichmäßiger sowohl auf den Umfang als auch entlang der Längsachse der Rohrfeder verteilt werden. Die Stegbreite zwischen den einzelnen Ausnehmungen in Querrichtung kann dabei konstant gehalten werden.

Üblicherweise ist die maximale Längsausdehnung einer Ausnehmung zumindest im Wesentlichen quer zur Rohrfederachse ausgerichtet.

Vorteilhafterweise sind die Querschnittskonturlinien der Ausnehmungen an den jeweiligen Enden in Längsrichtung abgerundet und können vorzugsweise durch einen Radius beschrieben werden. Da die Ausnehmungen vorzugsweise zunächst durch Stanzen der Ausnehmungen aus einem Federstahl-Zuschnitt hergestellt werden, sind abgerundete, durch einen Radius beschreibbare Ausnehmungs-Enden besonders einfach herzustellen, da im Vergleich zu beispielsweise gewinkelten Enden weniger Formfehler beispielsweise durch Stanzgrate, auftreten können. Vorteilhafterweise weisen die Ausnehmungen verschiedener Querausdehnungen entsprechend auch unterschiedliche Radien ihrer Enden in Längsrichtung auf. Eine Ausnehmung mit größerer Querausdehnung weist entsprechend einen größeren Radius an ihrem Längsende auf als eine Ausnehmung kleinerer Querausdehnung.

Vorteilhafterweise sind innerhalb einer Reihe von Ausnehmungen zwei oder mehr Ausnehmungen jeweils verschiedener Querausdehnungen angeordnet, um zumindest in Umfangsrichtung ungleichmäßige Belastungen in der Rohrfeder über den Rohrfederumfang auszugleichen. Vorzugsweise sind zwei oder mehr Ausnehmungen jeweils verschiedener Querausdehnungen in mehreren Reihen von Ausnehmungen angeordnet, so dass ungleiche Quer- und Längsbelastungen in der Rohrfeder bestmöglich über die gesamt Rohrfederstruktur gleichmäßig verteilt werden können.

Besonders vorteilhafterweise wechseln sich die zumindest zwei oder mehr Ausnehmungen entlang einer Reihe von Ausnehmungen jeweils ab.

Da sich insbesondere die ungleichmäßigen Belastungen in der Rohrfeder von den beiden Stoßkanten ausgehend über die Rohrfeder verteilen, kann es weiterhin von Vorteil sein, wenn sich solche Ausnehmungen, die über die Stoßkanten hinweg verlaufen und folglich durch die beiden Stoßkanten geteilt werden, längs der Rohrfederachse jeweils in ihren Querschnittsausdehnungen unterscheiden. Beispielsweise können in Längsrichtung der Rohrfeder entlang der Stoßkanten aufeinanderfolgende Ausnehmungen abwechselnd unterschiedliche Endradien aufweisen. So wird besonderes effektiv eine ungleichmäßige Belastung, die an den Stoßkanten an die Rohrfeder eingebracht wird, bereits am Ort des Entstehens möglichst gleichmäßig entlang der gesamten Längsrichtung der Rohrfeder verteilt werden.

Die hier aufgeführten Ausführungsformen können zudem in beliebiger Weise auch untereinander kombiniert werden. Ausfüh-Die hier aufgeführten Ausführungsformen können zudem in beliebiger Weise auch untereinander kombiniert werden. Ausführungsbeispiele sind im Folgenden anhand von schematischen Zeichnungen erläutert. Es zeigen:
- Figur 1: ein Schnittbild durch eine piezoelektrische Aktoreinheit,
- Figur 2A: eine Ausführungsform eines bekannten Hohlkörpers zum Vorspannen eines piezoelektrischen Aktors als Rohrfeder,
- Figur 2B: eine Schnittansicht der Rohrfeder gemäß Figur 2A,
- Figur 3: einen Ausschnitt aus einer bekannten Rohrfeder im ausgerollten Zustand,
- Figur 4: eine erste Ausführungsform einer erfindungsgemäßen Rohrfeder,
- Figur 5: eine zweite Ausführungsform einer erfindungsgemäßen Rohrfeder,

Elemente gleicher Konstruktion oder Funktion sind figurenübergreifend mit den gleichen Bezugszeichen versehen.

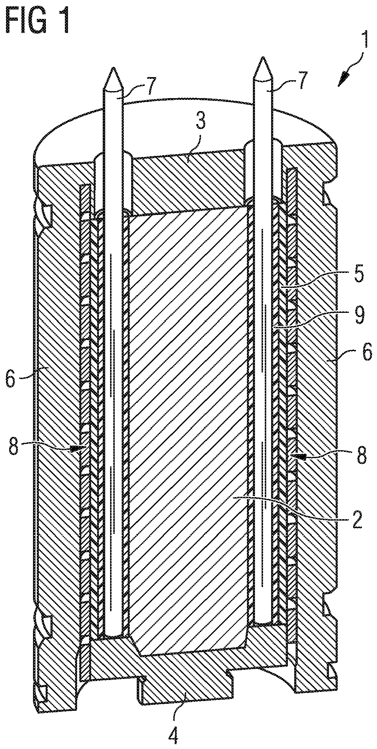

Figur 1 zeigt ein Schnittbild durch eine piezoelektrische Aktoreinheit 1, die insbesondere als Antriebseinheit zur Betätigung einer Einspritzdüse in einem Kraftstoffinjektor verwendbar ist. Die piezoelektrische Aktoreinheit 1 weist ein Aktormodul 2 auf, das aus mehreren hundert piezoelektrischen Keramikschichten in Form eines Stapelaktors aufgebaut ist. Zwischen jeweils zwei Keramikschichten ist eine Innenelektrode angeordnet, die wechselweise mit zwei an der Außenwand des Aktormoduls 2 vertikal verlaufenden Außenelektroden elektrisch leitend verbunden ist. Des Weiteren sind parallel zu den beiden Außenelektroden zwei Kontaktierungspins 7 angeordnet, die über entsprechende Leitungen mit den beiden Außenelektroden kontaktiert sind. Zur Montage wird das Aktormodul 2 mit den verdrahteten beiden Kontaktierungspins 7 in eine Kunststoffhülse (Montagehülse) 5 eingesetzt und fixiert. Die Kunststoffhülse 5 ist gleichzeitig als Gussform ausgebildet, in der die eingesetzten Bauteile 2,7 mit einer Vergussmasse 9, beispielsweise mit einem Vergusssilikon, Elastomer oder ähnlichem vergossen werden. Die Kunststoffhülse 5 ist aus einem Kunststoff, beispielsweise aus einem PA-Kunststoff (Polyamid) gefertigt.

An einem oberen Ende des Aktormoduls 2 ist eine Kopfplatte 3 angeordnet, die mit dem Aktormodul 2 kraftschlüssig verbunden ist. Die Kopfplatte 3 begrenzt somit das Aktormodul 2 nach oben. In der Kopfplatte 3 sind zwei isolierte Durchführungen für die beiden Kontaktierungspins 7 so ausgeführt, dass die herausragenden Enden der beiden Kontaktierungspins 7 später zur elektrischen Versorgung des Aktormoduls 2 an eine Steuerspannung eines entsprechenden Steuergerätes angeschlossen werden können.

Das untere Ende des Aktormoduls 2 wird von einer Bodenplatte 4 begrenzt, die ebenfalls mit dem Aktormodul 2 kraftschlüssig verbunden ist. Zwischen der Kopfplatte 3 und der Bodenplatte 4 ist eine Rohrfeder 8 hülsenförmig angeordnet und umschließt das vergossene Aktormodul 2. Die Rohrfeder 8 wird mit einer Vorspannkraft montiert, die auf das Aktormodul 2 als Rückstellkraft wirkt und somit eine Rückstellung des nicht angesteuerten Aktormoduls 2 in seine Grundstellung unterstützt.

Die ganze Baugruppe wird von einem Aktorgehäuse 6 hülsenförmig ummantelt. Das obere Ende des Aktorgehäuses 6 ist dabei mit der Kopfplatte 3 fest und abdichtend verbunden. Das untere Ende des Aktorgehäuses 6 ist dagegen gegenüber der Bodenplatte 4 axial beweglich angeordnet, aber ebenfalls kraftstoffdicht abgedichtet. Bei Ansteuerung des Aktormoduls 2 entsteht somit zwischen der Bodenplatte 4 und der Unterseite des Aktorgehäuses 6 eine geringe, axiale Hubbewegung, die zur Steuerung eines Servoventils, einer Düsennadel oder dergleichen genutzt werden kann.

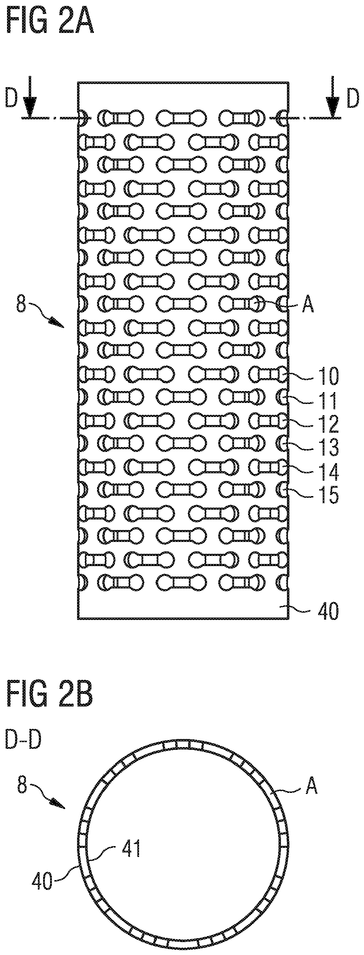

Figuren 2A und 2B zeigen den Aufbau einer bekannten Rohrfeder 8. Die Rohrfeder weist über seine gesamte Fläche bis auf die Randbereiche, an denen die Abdeckplatten 3, 4 befestigt werden, gleichmäßig verteilt Ausnehmungen A auf, die in dem gezeigten Ausführungsbeispiel knochenförmig ausgebildet sind und quer zur Achse durch die Rohrfeder verlaufen. Die Ausnehmungen A gewährleisten eine ausreichende Elastizität der den vorgespannten piezoelektrischen Aktor 2 aufnehmenden Rohrfeder 8, so dass die Rohrfeder die durch ein Anlegen einer Spannung an den piezoelektrischen Aktor 2 hervorgerufene Längung des Aktors 2 in Längsrichtung nur unwesentlich behindert. Die Elastizität der Rohrfeder 2 kann dabei durch die Anzahl und die Länge der Ausnehmungen A an die gewünschte Längendehnung des vorgespannten piezoelektrischen Aktors 2 angepasst werden.

Vorteilhaft ist hierbei auch die in den Figuren 2A und 2B gezeigte Anordnung der Ausnehmungen A versetzt übereinander. Diese Anordnung gewährleistet eine optimale Elastizität der Rohrfeder bei gleichzeitiger ausreichender Festigkeit, um die Vorspannung auf den piezoelektrischen Aktor 2 aufbringen zu können. Die Elastizität wird insbesondere auch durch die knochenförmige Form der Ausnehmungen A in diesem Ausführungsbeispiel unterstützt, bei der zwei kreisförmige Aussparungen über einen Schlitz miteinander verbunden sind. Bevorzugte Größenbereiche liegen bei den kreisförmigen Aussparungen bei Durchmessern von 0,8 mm bis 1,6 mm und bei den Abständen zwischen den Mittelpunkten der Aussparungen im Bereich von 1,5 mm bis 3,5 mm. Diese Form lässt sich weiterhin sehr einfach und genau z.B. durch Stanzen in einem Federstahlblech ausbilden.

Die Rohrfeder wird vorzugsweise aus einem Federstahlband mit einer Dicke von 0,5 mm gefertigt. In einem ersten Schritt werden dabei in das Federstahlband die Ausnehmungen A eingestanzt. Alternativ besteht auch die Möglichkeit, die Ausnehmungen durch Drahterodieren, Fräsen, Bohren oder mit elektrochemischen Verfahren auszubilden.

Nach dem Ausbilden der Ausnehmungen A wird das Federstahlband auf das für die Rohrfeder 8 gewünschte Maß zugeschnitten, wobei die Ausnehmungen A vorzugsweise mittig durchgeschnitten sind. Dann wird der Zuschnitt gerollt, wobei die Schnitt- bzw. Stanzkanten nach außen orientiert sind. Anschließend werden die Kanten entgratet und die Rohrform mit einer vorzugsweise durch einen Laser erzeugten Längs-Schweißnaht fixiert. Statt einer Fixierung der Rohrform durch Schweißen kann eine Fixierung auch durch die oberen und unteren Abdeckplatten 3, 4 erfolgen, so dass die Stoßkanten nur aneinander anliegen.

Figur 2B zeigt eine Schnittbilddarstellung der Rohrfeder 8 gemäß Figur 2A. Dargestellt ist exemplarisch eine Ausnehmung A sowie die Außenoberfläche 40 und die Innenoberfläche 41 der Rohrfeder 8.

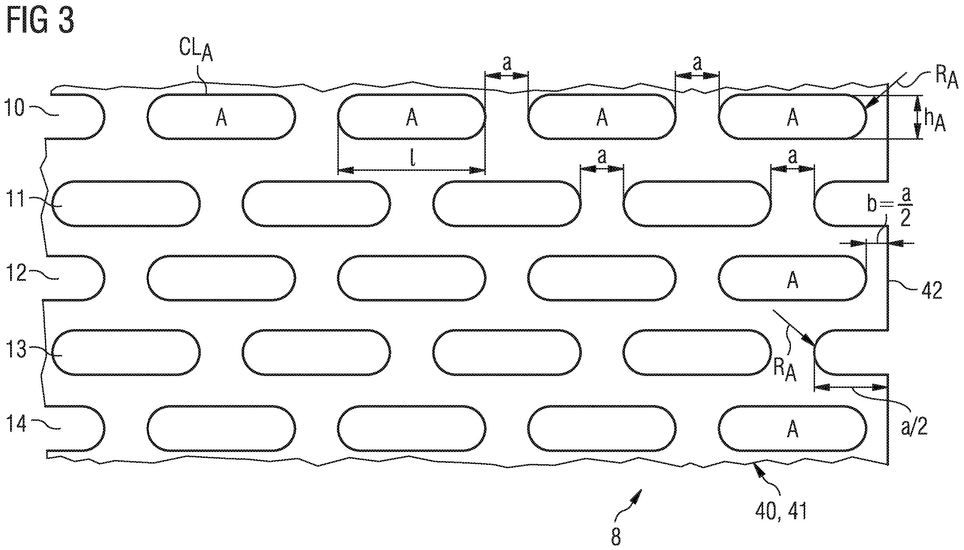

Figur 3 zeigt einen Ausschnitt aus einer bekannten Rohrfeder 8 im ausgerollten Zustand. Dargestellt ist eine im Vergleich zu den Figuren 2A und 2B alternative Ausführungsform der Ausnehmungen A, bei der die Ausnehmungen A eine rechteckige Grundform aufweisen, die an den beidseitigen Enden der Ausnehmungen A abgerundet sind und dort durch einen Radius R_{A} beschrieben werden können. Die Ausnehmungen A werden in ihrer äußeren Form auf je einer der Oberflächen 41, 42 durch ihre Querschnittskonturlinie CL beschrieben. Folglich geht die Querschnittskonturlinie CL an den beidseitigen Enden der Ausnehmungen A in den Radius R_{A} über.

Senkrecht zur Längsausrichtung der Ausnehmungen A legt die Querschnittskonturlinie CL eine maximale Querausdehnung h_{A} der Ausnehmungen A fest. Die Ausnehmungen A sind in Umfangsrichtung der Rohrfeder 8 durch Stege der Breite a voneinander beabstandet angeordnet, wobei die Stegbreite a insbesondere auch konstant sein kann; alternativ aber auch variabel.

Dargestellt ist ebenfalls eine Stoßkante 42 der Rohrfeder 8. Vorzugweise werden hier die Ausnehmungen A in ihrer Längsausdehnung halbiert, so dass die beiden halben Ausnehmungen bei der fertigen Rohrfeder 8 über die Stoßkante hinweg jeweils eine Ausnehmung A bilden; und somit gleich zu den übrigen Ausnehmungen A, die nicht an der Stoßkante angeordnet sind.

Die gezeigte Ausführungsform einer Rohrfeder 8 weist nur eine Variante von Ausnehmungen A auf, die jeweils sowohl die gleiche maximale Längsausdehnung 1 als auch eine maximale Querausdehnung h_{A} aufweisen.

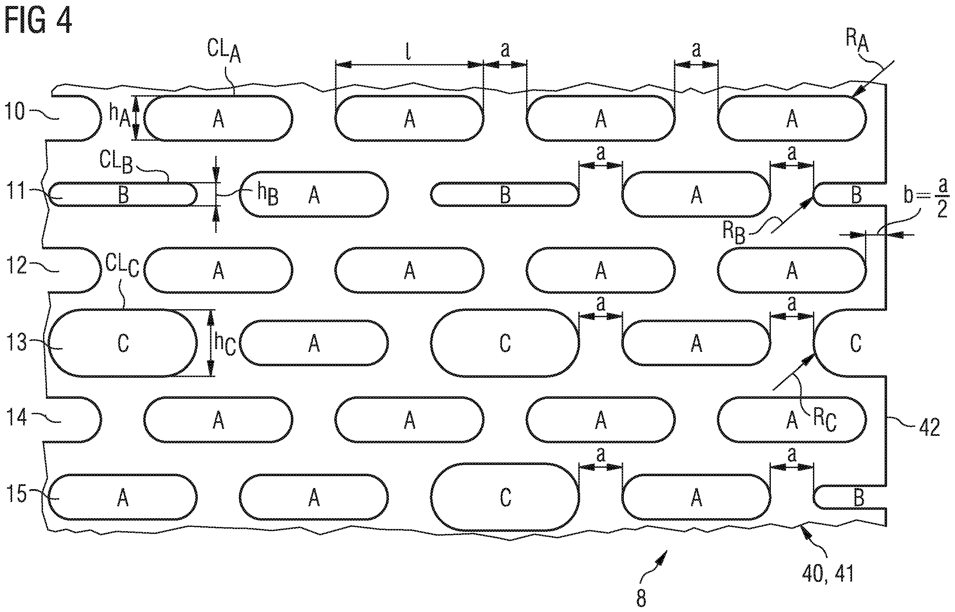

In analoger Darstellung wie Figur 3 zeigt die Figur 4 eine erste Ausführungsform für eine erfindungsgemäße Rohrfeder 8. Dargestellt sind Ausnehmungen A des ersten Typs mit einer maximalen Querausdehnung h_{A} in den Reihen 10, 12, 14, jeweils verteilt entlang des Umfangs einer Außen- oder Innenoberfläche 41, 42 der Rohrfeder 8. Gemäß dieser erfindungsgemäßen Ausführungsform der Rohrfeder 8 sind zusätzlich zu den Ausnehmungen A auch Ausnehmungen B mit einer maximalen Querausdehnung h_{B} entlang des Rohrfederumfangs angeordnet, in Reihe 11. Umlaufend wechseln sich die Ausnehmungen A und B jeweils ab, wobei über die Stoßkanten hinweg zwei entsprechende halbe Ausnehmungen eine Ausnehmung B bilden.

Auch die Ausnehmungen B sind an ihren längsseitigen Enden jeweils abgerundet. Die Rundungen lassen sich durch einen Radius R_{B} beschreiben, der kleiner ist als der entsprechende Radius R_{A} einer Ausnehmung des Typs A. Zusätzlich sind beispielsweise in Reihe 13 Ausnehmungen eines Typs C in der Rohrfeder 8 angeordnet, deren maximale Querausdehnung h_{C} größer als die maximale Querausdehnung h_{A} der Ausnehmungen des Typs A sind. Auch diese Ausnehmungen B sind entlang des Umfangs der Rohrfeder 8 (auf der Außenoberfläche 41 oder Innenoberfläche 42) jeweils abwechselnd mit Ausnehmungen des Typs A angeordnet. Analog zur Anordnung in Reihe 11 ist auch in Reihe 13 eine Ausnehmung des Typs C über die Stoßkante 42 hinweg angeordnet.

Auch die Ausnehmungen des Typs C weisen abgerundete Endbereiche auf, die durch einen Radius R_{C} beschrieben werden können, wobei R_{C} > R_{A}.

In Reihe 15 sind Ausnehmungen aller drei dargestellten Typen A, B und C angeordnet.

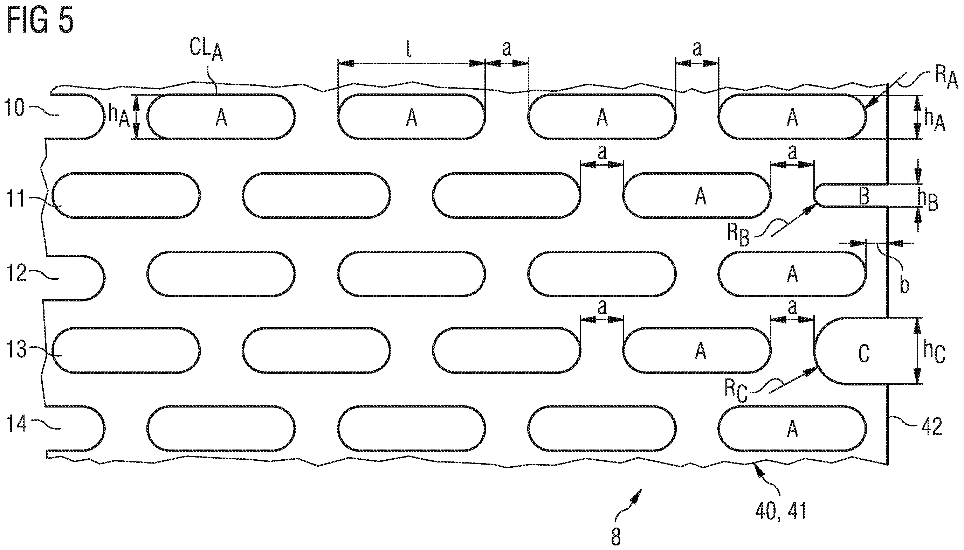

Figur 5 zeigt eine alternative Ausführungsform einer erfindungsgemäßen Rohrfeder 8. In dieser Ausführungsform sind nur über die Stoßkante 42 hinweg Ausnehmungen der Typen B und C angeordnet. In der Darstellung der Figur 5 betrifft dies nur die Reihen 11 und 13, in denen Ausnehmungen B bzw. C über die Stoßkante 42 hinweg angeordnet sind. Im Übrigen weist die Rohrfeder 8 gemäß dieser Ausführungsform auf jeweils einer Oberflächenseite 40, 41 ausschließlich Ausnehmungen des Typs A auf. Durch eine Anordnung von Ausnehmungen unterschiedlichen Typs über die Stoßkante 42 hinweg werden die an den Stoßkanten eingebrachten ungleichmäßigen Belastungen auf die Rohrfeder 8 bereits an ihrem Entstehungsort möglichst gleichmäßig in Längs- und Querrichtung der Rohrfeder 8 verteilt.

Die Erfindung ist jedoch selbstverständlich nicht auf die beiden Ausführungsformen der Figuren 4 und 5 beschränkt. Alternativ können auch andere Anordnungen von Ausnehmungen verschiedener maximaler Querausdehnungen in einer Rohrfeder 8 verwirklicht werden, beispielsweise können auch mehr als drei Ausnehmungen verschiedenen Typs, mit jeweils verschiedener maximaler Querausdehnung im Sinne dieser Erfindung eingesetzt werden.

## Patentansprüche

1. Rohrfeder (8) zur Aufnahme und zum Vorspannen eines piezoelektrischen oder magnetostriktiven Aktors (2) einer Aktoreinheit (1),
welche insbesondere zur Betätigung eines Brennstoffeinspritzventils für Brennkraftmaschinen geeignet ist,
mit mehreren Reihen (9, 10, 11, 12, 13) von Ausnehmungen (A, B, C), die jeweils von der Außenoberfläche (40) der Rohrfeder (8) bis zu deren Innenoberfläche (41) reichen, wobei
- die Ausnehmungen (A, B, C) auf jeder der beiden Oberflächenseiten eine jeweilige Querschnittskonturlinie aufweisen und durch diese Querschnittskonturlinie (CL_{A}, CL_{B}, CLc)
- jeweils eine maximale Längsausdehnung (Länge 1) einer Ausnehmung (A, B, C) sowie
- jeweils eine maximale Querausdehnung (Breite h_{A}, h_{B}, h_{C}), die im Wesentlichen senkrecht zur Längsausdehnung ausgerichtet ist,
definiert wird,
- sich zumindest die jeweiligen maximalen Querausdehnungen (h_{A}, h_{B}, h_{C}) zweier Ausnehmungen (A,B,C) auf derselben der beiden Oberflächen (40,41) der Rohrfeder (8) voneinander unterscheiden und
- die Rohrfeder (2) zwei Stoßkanten (42) aufweist, die einander zugeordnet sind und sich über die gesamte Länge der Rohrfeder erstrecken,
**dadurch gekennzeichnet, dass**
entlang der Stoßkanten (42) Ausnehmungen (A, B, C) unterschiedlicher maximaler Querausdehnungen angeordnet sind, die sich über die Stoßkanten hinweg erstrecken.

2. Rohrfeder nach Anspruch 1,
**dadurch gekennzeichnet, dass**
die Querschnittskonturlinien (CL_{A}, CL_{B}, CL_{C}) der Ausnehmungen (A, B, C) an den in Längsrichtung beiden Enden der Ausnehmungen (A, B, C) jeweils abgerundet sind.

3. Rohrfeder nach Anspruch 2,
**dadurch gekennzeichnet, dass**
die Querschnittskonturlinien (CL_{A}, CL_{B}, CL_{C}) der Ausnehmungen (A, B, C) an den jeweils beiden Enden in Längsrichtung durch jeweils einen Radius (R_{A}, R_{B}, R_{C}) beschrieben werden können.

4. Rohrfeder nach Anspruch 3,
**dadurch gekennzeichnet, dass**
die Ausnehmungen (A, B, C) verschiedener Querausdehnungen (h_{A}, h_{B}, h_{C}) entsprechend verschiedene Radien (R_{A}, R_{B}, R_{C}) an ihren Enden aufweisen.

5. Rohrfeder (8) nach einem der vorhergehenden Ansprüche, **dadurch gekennzeichnet, dass**
zumindest innerhalb einer Reihe zwei oder mehr Ausnehmungen jeweils verschiedener Querausdehnungen (h_{A}, h_{B}, h_{C}) angeordnet sind.

6. Rohrfeder (8) nach einem der vorhergehenden Ansprüche, **dadurch gekennzeichnet, dass**
sich zumindest zwei oder mehr Ausnehmungen entlang der Reihenachse abwechseln.

7. Rohrfeder (8) nach einem der vorhergehenden Ansprüche, **dadurch gekennzeichnet, dass**
- die Rohrfeder (8) aus Metall gefertigt ist, insbesondere aus Federstahl, und
- die Ausnehmungen (41) eingestanzt sind.

## Claims

1. Tubular spring (8) for receiving and preloading a piezoelectric or magnetostrictive actuator (2) of an actuator unit (1)
which is suitable, in particular, for actuating a fuel injector valve for internal combustion engines,
having a plurality of rows (9, 10, 11, 12, 13) of apertures (A, B, C), each extending from the outer surface (40) of the tubular spring (8) to the inner surface (41) thereof, wherein
- the apertures (A, B, C) have respective cross-sectional contour lines on each of the two surface sides, and said cross-sectional contour lines (CL_{A}, CL_{B}, CL_{C}) in each case define
- a maximum longitudinal extent (length 1) of an aperture (A, B, C) and
- a maximum transverse extent (width h_{A}, h_{B}, h_{C}) oriented substantially perpendicularly to the longitudinal extent,
- at least the respective maximum transverse extents (h_{A}, h_{B}, h_{C}) of two apertures (A, B, C) on the same of the two surfaces (40, 41) of the tubular spring (8) differ from one another and
- the tubular spring (2) has two abutting edges (42), which are associated with one another and extend over the entire length of the tubular spring,
**characterized in that**
apertures (A, B, C) of different maximum transverse extents are arranged along the abutting edges (42), extending across the abutting edges.

2. Tubular spring according to Claim 1,
**characterized in that**
the cross-sectional contour lines (CL_{A}, CL_{B}, CL_{C}) of the apertures (A, B, C) are in each case rounded at the two ends of the apertures (A, B, C) in the longitudinal direction.

3. Tubular spring according to Claim 2,
**characterized in that**
the cross-sectional contour lines (CL_{A}, CL_{B}, CL_{C}) of the apertures (A, B, C) at each of the two ends in the longitudinal direction can be described by respective radii (R_{A}, R_{B}, R_{C}).

4. Tubular spring according to Claim 3,
**characterized in that**
the apertures (A, B, C) of different transverse extents (h_{A}, h_{B}, h_{C}) correspondingly have different radii (R_{A}, R_{B}, R_{C}) at the ends thereof.

5. Tubular spring (8) according to one of the preceding claims,
**characterized in that**
two or more apertures, each of different transverse extents (h_{A}, h_{B}, h_{C}), are arranged at least within one row.

6. Tubular spring (8) according to one of the preceding claims,
**characterized in that**
at least two or more apertures alternate along the axis of the row.

7. Tubular spring (8) according to one of the preceding claims,
**characterized in that**
- the tubular spring (8) is manufactured from metal, in particular from spring steel, and
- the apertures (41) are punched in.

## Revendications

1. Ressort tubulaire (8) destiné à la réception et à la sollicitation préalable d'un actionneur (2) piézoélectrique ou magnétostrictif d'une unité d'actionnement (1),
laquelle est en particulier configurée en vue de l'actionnement d'une soupape d'injection de carburant pour des moteurs à combustion interne,
avec plusieurs rangées (9, 10, 11, 12, 13) de cavités (A, B, C) qui s'étendent respectivement depuis la surface externe (40) du ressort tubulaire (8) jusqu'à leur surface interne (41) ; selon lequel
- les cavités (A, B, C) présentent une ligne de contour respective de la section transversale sur chacun des deux côtés de la surface et, par l'intermédiaire de cette ligne de contour de la section transversale (CL_{A}, CL_{B}, CL_{C}),
- une extension longitudinale maximale (longueur 1) d'une cavité (A, B, C) est définie respectivement ; et
- une extension transversale maximale (largeur h_{A}, h_{B}, h_{C}) est définie respectivement, laquelle est, pour l'essentiel, alignée de manière perpendiculaire par rapport à l'extension longitudinale ;
- les extensions transversales maximales (h_{A}, h_{B}, h_{C}) respectives de deux cavités (A, B, C) se trouvant sur les mêmes des deux surfaces interne et externe (40, 41) du ressort tubulaire (8) se distinguent tout au moins les unes des autres ; et
- le ressort tubulaire (2) présente deux bordures de jonction (42) qui sont associées l'une à l'autre et qui s'étendent sur toute la longueur du ressort tubulaire ;
**caractérisé en ce que**
des cavités (A, B, C) présentant différentes extensions transversales maximales sont disposées le long des bordures de jonction (42), lesquelles s'étendent au delà des bordures de jonction.

2. Ressort tubulaire selon la revendication 1,
**caractérisé en ce que**
les lignes de contour de la section transversale (CL_{A}, CL_{B}, CL_{C}) des cavités (A, B, C) sont respectivement arrondies, dans la direction longitudinale, au niveau des deux extrémités des cavités (A, B, C).

3. Ressort tubulaire selon la revendication 2,
**caractérisé en ce que**
les lignes de contour de la section transversale (CL_{A}, CL_{B}, CL_{C}) des cavités (A, B, C) au niveau des respectivement deux extrémités dans la direction longitudinale peuvent être décrites respectivement par un rayon (R_{A}, R_{B}, R_{C}).

4. Ressort tubulaire selon la revendication 3,
**caractérisé en ce que**
les cavités (A, B, C) de différentes extensions transversales (h_{A}, h_{B}, h_{C}) présentent, au niveau de leurs extrémités, des rayons (R_{A}, R_{B}, R_{C}) différents de manière correspondante.

5. Ressort tubulaire (8) selon l'une des revendications précédentes,
**caractérisé en ce que**
deux cavités ou plus de deux cavités d'extensions transversales (h_{A}, h_{B}, h_{C}) respectivement différentes sont disposées tout au moins au sein d'une rangée.

6. Ressort tubulaire (8) selon l'une des revendications précédentes,
**caractérisé en ce que**
tout au moins deux cavités ou plus de deux cavités sont disposées en alternance le long de l'axe de la rangée.

7. Ressort tubulaire (8) selon l'une des revendications précédentes,
**caractérisé en ce que**
- le ressort tubulaire (8) est fabriqué en métal, en particulier en acier à ressorts ; et
- les cavités (41) sont estampées.
